# EUROPEAN PATENT SPECIFICATION

(11) **EP 3 867 704 B1**
(45) Date of publication and mention of the grant of the patent: **07.12.2022**
(21) Application number: 18815336.5
(22) Date of filing: 16.10.2018
(51) Int. Cl.: G03F 7/00, G03F 7/027, G03F 7/029, G03F 7/031, G03F 7/038

(54) **PHOTOSENSITIVE COMPOSITION FOR 3D PRINTING**
LICHTEMPFINDLICHE ZUSAMMENSETZUNG ZUM 3D-DRUCKEN
COMPOSITION PHOTOSENSIBLE POUR IMPRESSION 3D

(43) Date of publication of application: 25.08.2021
(73) Proprietor: Universita' Degli Studi Di Pavia, 27100 Pavia (IT)
(72) Inventor: DONDI, Daniele, 27100 Pavia (IT)
(74) Representative: PGA S.p.A.
(86) International application number: PCT/IB2018/057998
(87) International publication number: WO 2020/079470

(56) References cited:
- EP-A1- 2 703 461
- CN-A- 107 189 047
- CN-A- 108 047 729
- CN-A- 108 587 100
- US-A- 4 077 925
- US-A1- 2006 216 489

## Description

### FIELD OF THE INVENTION

The present invention regards photosensitive resins for 3D printing obtained starting from oils of vegetable origin.

### STATE OF THE ART

Three-dimensional (3D) printing represents a new technology, in continuous development, which allows passing from a simple printing on paper to printing three-dimensional objects by means of the use of a 3D modeling software.

The prints are produced by employing an additive technique, i.e. the process consists of superimposing layers of material capable of being aggregated in order to form a complete object.

With respect to the conventional production techniques, production by means of 3D printing has the advantage of being able to make any shape in a single piece, without having to carry out welding or gluing operations.

In recent years the cost of 3D printers has considerably lowered, becoming economically accessible to small and mid-size companies and facilitating the entrance thereof in offices. This technology has been inserted in the following fields: jewelry, footwear, industrial design, architecture, aerospace field, medical and dental fields.

3D printers differ from each other due to the technology used during the printing steps, in two large categories represented by (i) filament melting systems (FDM), and (ii) stereolithographic photoinduced polymerization systems (SLA).

The stereolithographic printing systems can also be divided into "Digital Light Processing" systems (DLP), (ii) "Selective Laser Sintering" systems (SLS), and (iii) "Two-Photon Polymerization" (2PP) systems.

Stereolithography uses liquid resins - which constitute or comprise the monomer - mixed with a photoinitiator which reacts if exposed to ultraviolet or visible light. When the photoinitiators are hit by photons, they trigger the polymerization of the resin monomer, which forms the solid polymer.

The laser stereolithographic technique employs a single light ray (focused or laser) in order to polymerize a photosensitive resin, designing thereon fine layers of polymer which are repeated and superimposed until completing the printing.

The SLA laser machines can reach dimensions of voxels (volumetric pixels) on the order of 100 µm, while the printers with DLP technology are capable of creating voxels of only 30 µm. This greater resolution is translated into high-quality surface finishes, which are more enjoyable to the touch and require less processing downstream with respect to other 3D printing techniques.

The DLP printers can also be divided into two large categories which differ due to the printing process which can be (i) immersion, in which the base on which the object is formed is progressively immersed in the photosensitive resin, or (ii) emersion, in which the base on which the object is formed progressively emerges from the photosensitive resin.

The printers with DLP technology can very quickly generate highresolution objects, especially those with large and complex layers, since these machines produce an entire layer simultaneously, while the laser printers must trace every single element of the layer.

By uniting high resolution, material selection and high speeds, the printers with DLP technology offer benefits in all fields where 3D printing can be applied.

The industrial resins currently present on the market are composed of very toxic and polluting substances. The exact chemical compositions of these resins are usually secret; nevertheless, the safety sheets clearly indicate that these contain acrylate monomers and/or methacrylate monomers. Such compounds are already known to be dangerous for human health; for example, the acrylate monomers can be acutely toxic if inhaled, ingested or if they come into contact with the skin. Different research studies have indicated that the 3D printed parts can be toxic, cause allergic or inflammatory reactions and infections for the users. In addition, based on the printer type and on the material used, potentially dangerous particles are released in the air during operation, and sometimes volatile compounds are released (VOC-Volatile Organic Compounds).

A recent study has evaluated the toxicity of these 3D printed parts by using a zebrafish (Danio rerio), a model organism that is widely used in aquatic toxicology. Zebrafish embryos were exposed to 3D printed parts and monitored for the survival rates, nesting rates and developmental abnormalities. The embryos exposed to parts printed with SLA had significantly reduced survival rates (p ≤ 0.05), with over half of the embryos dead after the third day and all dead by the seventh day, which was the end of observation. From the few zebrafish embryos that opened after exposure to parts printed with STL, 100% of the small fish had malformations (Macdonald N.P.et al., "Assessment of biocompatibility of 3D printed photopolymers using zebrafish embryo toxicity assays" Lab on a Chip. 2016;16(2):291-297).

CN 108 587 100 A discloses a UV-sensitive resin for 3D printing comprising a vegetable oil based component.

The non-biocompatibility of the photopolymerizable polymer does not allow applying stereolithography, in particular micro-stereolithography, to biomedical or biological fields, notwithstanding the wide needs for such fields.

In addition, with the increasing diffusion of 3D printers, both at the professional and amateur level, the quantity of 3D printed components, and hence of waste derived from this technology, will increase in an exponential manner. This could cause an accumulation in the environment, since the users of these printers might not have the necessary training to use them in a safe manner and to dispose of their waste in a responsible manner, and the municipal agencies for waste disposal might not have the resources for the collection and treatment of the 3D printer waste.

### SUMMARY OF THE INVENTION

The Applicant has faced the problem of finding a material usable for stereolithographic printing which overcomes the problems known in the art.

In particular, the Applicant has faced the problem of making a photopolymerizable resin starting from biocompatible natural products, which do not give toxicity problems, which are easily found and inexpensive, and which could also be easily disposed of in the environment and are biodegradable.

The Applicant has observed that vegetable oils, even waste vegetable oils, i.e. already used for cooking foods, can be used for preparing a photosensitive resin capable of being used in 3D printers which use stereolithographic technology.

The Applicant has in fact observed that by treating, in suitable conditions, the vegetable oil with glycerin it was possible to obtain a monoglyceride from which, by reaction with maleic anhydride and subsequent mixture with a photoinitiator and N-vinylpyrrolidone, it was possible to obtain a photopolymerizable liquid resin capable of being used in 3D printers which use stereolithographic technology.

The Applicant has observed that the use of vegetable oils, even waste vegetable oils, involved the further advantage of providing a further disposal and recycling form for such waste oils, up to now use as raw material for the preparation of so-called bio-diesel.

Therefore, a first aspect of the present invention relates to a process for producing a photosensitive resin for 3D printing characterized in that it comprises the following steps:
(i) treating a vegetable oil with a polyol selected from the group which consists of polyols comprising 2 to 6 carbon atoms and at least 2 hydroxyl groups to form a monoglyceride,
(ii) reacting the monoglyceride of step (i) with an unsaturated reagent selected from the group which consists of acids, esters or anhydrides comprising at least one carboxylic group and at least one double bond to form a liquid resin with a viscosity measured with a rotational viscometer of lower than 20 Pa·s at the temperature of 20°C,
(iii) mixing the liquid resin with (a) a comonomer selected from the group which consists of vinyl and acrylic monomers, and (b) a photoinitiator.

### BRIEF DESCRIPTION OF THE FIGURES

Figure 1 illustrates the printing cycle used in the exploratory tests of example 1.
Figure 2 illustrates the results obtained in the print test of example 3 with the photosensitive resin Rfot R2.
Figures 3A-D illustrate the results obtained in the print test of example 3 with the photosensitive resin Rfot G2.
Figures 4A-C illustrate the results obtained in the print test of example 3 with the photosensitive resin Rfot C2 and C3.

### DETAILED DESCRIPTION OF THE INVENTION

According to a preferred aspect of the process for producing a photosensitive resin for 3D printing of the present invention the vegetable oil is selected from the group which consists of fresh vegetable oils at high and low unsaturation, and mixtures of recovery vegetable oils, preferably food vegetable oils.

Examples of food vegetable oils which can be used in the present invention are: olive oil, linseed oil, grape seed oil, coconut oil, palm oil and palm-kernel oil, corn oil, sunflower oil, sesame seed oil, wheat germ oil, jojoba oil, hemp oil, castor oil, evening primrose oil, avocado oil, soybean oil, rice bran oil, safflower oil, rape oil, peanut oil, walnut oil, macadamia oil.

Advantageously, the vegetable oil is selected from the group which consists of olive oil, sunflower oil, peanut oil, corn oil, various seed oils, palm oil, rape oil, mixtures of frying oils.

According to a preferred aspect of the process for producing a photosensitive resin for 3D printing of the present invention, the polyol is selected from the group which consists of ethylene glycol, glycerin, pentaerythritol, adonitol, allitol, altritol, arabinitol, dulcitol, erythritol, galaxitol, glucitol, guliltol, iditol, inositol, isomalt, lactitol, lisitol, maltitol, mannitol, perseitol, ribitol, rhamnitol, sorbitol, talitol, threitol, xylitol, and mixtures thereof.

According to a particularly preferred aspect of the process for producing a photosensitive resin for 3D printing of the present invention, the polyol is selected from the group which consists of glycerin, pentaerythritol, mannitol, and mixtures thereof.

According to a preferred aspect of the process for producing a photosensitive resin for 3D printing of the present invention, the unsaturated reagent is selected from the group which consists of maleic anhydride, succinic anhydride, phthalic anhydride, itaconic anhydride, ethyl maleate, itaconic acid, maleic acid, fumaric acid and mixtures thereof.

Advantageously, the unsaturated reagent is selected from the group which consists of maleic anhydride, ethyl maleate, and mixtures thereof.

According to a preferred aspect of the process for producing a photosensitive resin for 3D printing of the present invention, the comonomer is selected from the group which consists of vinyl monomers, such as for example N-vinylpyrrolidone, N-vinylcarbazole, triethylene glycol divinyl ether, vinyltoluene and ethyl maleate.

According to a preferred alternative aspect of the process for producing a photosensitive resin for 3D printing of the present invention, the comonomer is selected from the group which consists of acrylic monomers, such as for example polyethylene glycol diacrylate, hexanediol diacrylate, methyl methacrylate, methacrylic acid and acrylic acid.

According to a preferred aspect of the process for producing a photosensitive resin for 3D printing of the present invention, the photoinitiator is selected from the group which consists of acylphosphine oxides, curcumin, benzophenones and derivatives, camphorquinone, anthraquinones and derivatives, xanthone and derivatives, thioxanthone and derivatives.

Advantageously, the photoinitiator is selected from the group which consists of phenylbis(2,4,6-trimethylbenzoyl)phosphine oxide (BAPO), diphenyl(2,4,6- trimethylbenzoyl)phosphine oxide (TPO), and curcumin.

According to a preferred aspect of the process for producing a photosensitive resin for 3D printing of the present invention, the liquid resin has a viscosity greater than 100 mPa·s at the temperature of 20°C.

Advantageously, the liquid resin has a viscosity comprised between 15 and 0.2 Pa·s, preferably between 10 and 0.5 Pa·s.

According to a preferred aspect of the process for producing a photosensitive resin for 3D printing of the present invention, the treatment of the vegetable oil with the polyol of step (i) occurs at a temperature comprised between 180°C and 230°C, preferably between 200°C and 220°C, for a time comprised between 15 and 180 minutes, preferably between 60 and 120 minutes.

Advantageously, the treatment step (i) is conducted under nitrogen atmosphere.

Advantageously, the starting oil is treated with an anhydrifying agent, such as for example anhydrous sodium sulfate or anhydrous magnesium sulfate, and then subjected to filtration in order to eliminate the water traces.

Advantageously, the treatment step (i) is conducted in the presence of a basic catalyst, such as lithium hydroxide or sodium hydroxide, inserted at the start of the reaction.

Preferably, the concentration of the basic catalyst in the reaction mixture is comprised in the interval of 0.01-0.03 % by weight over the total weight of the reaction mixture.

In order to verify the reaction that took place, a sample is taken from the reactor and this is mixed with a quantity of ethanol equal in volume to that of the drawn liquid. If after a brief stirring a single phase is obtained that is not turbid, the reaction is considered to be terminated.

According to a preferred aspect of the process for producing a photosensitive resin for 3D printing of the present invention, the reaction of step (ii) between the monoglyceride of step (i) with the unsaturated reagent occurs at two times conducted at different temperature.

Preferably, the unsaturated reagent is usually dosed with a stoichiometric defect that can vary from 10 to 40 % in accordance with the oil. This condition serves for preventing the gelling of the material at room temperature.

Advantageously, the reaction step (ii) is conducted at a first time by heating up to a temperature comprised between 120°C and 170°C, preferably between 140°C and 160°C, more preferably at about 150°C, and then making the reaction to occur at such temperature for a time comprised between 15 minutes and 2 hours, preferably between 40 and 70 minutes, and subsequently at a second time by heating up to a temperature comprised between 190°C and 220°C, preferably between 200°C and 220°C, more preferably at about 205°C, and then making the reaction to occur at such temperature for a time comprised between 15 and 90 minutes, preferably between 20 and 30 minutes.

Preferably, the time necessary for the reaction can be determined when the evolution of reaction water decreases until ceasing.

Advantageously, the reaction step (ii) is conducted under nitrogen atmosphere.

According to a preferred aspect of the process for producing a photosensitive resin for 3D printing of the present invention, the mixing step (iii) comprises the addition of a coloring agent.

Preferably, the coloring agent is selected from the group which consists of Sudan I, Sudan III, Sudan IV, curcumin, E102 and other liposoluble food coloring agents, preferably of red and yellow color.

Advantageously, the coloring agent is selected from the group which consists of Sudan I and liposoluble food coloring agents.

The quantity of coloring agent introduced in the photosensitive resin depends on various factors, including the type of printer used, the type of photoinitiator used, and the light source used for activating the photoinitiator.

In particular, if a photoinitiator active at 400-405 nm is considered, it is necessary to calculate a concentration of coloring agent which, in that wavelength interval, attenuates the light by 30-50% in the desired print layer. For example, if a minimum print thickness of 0.2 mm is desired, the absorbance of the coloring agent must be 7.5-15 relative absorbance units at 1 cm.

The present invention is then further illustrated with reference to the following non-limiting examples.

### Example 1

### Preparation of the photosensitive resin

For the synthesis in liquid phase, a 1000 ml and 500 ml compact minireactor was employed with mechanical stirring and electrical heating with temperature and rotation adjustable by a microcontroller by means of the integrated sensors, constituted by an aluminum block for the transmission of heat at high speed and a uniform distribution of the temperature with slots for the internal viewing of the reaction.

The vegetable oil is transformed into monoglyceride by treatment with glycerin and lithium hydroxide, the latter having catalyst function.

In the case of use of waste vegetable oil, this was first filtered in order to eliminate possible residues due to the preceding use of the oil (frying residues, residues of food under oil, and so forth) and then reacted with anhydrous sodium sulfate in order to eliminate the moisture of the oil, which can cause problems such as drops explosion at temperatures around 220 °C in reaction step.

Three samples of vegetable oil were used. The sample R is a waste vegetable oil composed of a single type of seed oil coming from a restaurant, the sample C is a waste vegetable oil containing various oil types, including extra-virgin olive oil, coming from a domestic used oil collection center of a large restaurant chain, and the sample G is composed of fresh sunflower oil (never used for cooking).

All the reagents, suitably weighed, were mixed within the reactor and the reaction was conducted under nitrogen, so as to ensure an inert environment, at the temperature of 220°C and stirring set at 180 revolutions/minute.

The quantities of reagents and the time necessary for completing the reaction are indicated for each sample in the following Table 1.

**TABLE 1**

| | Oil (g) | Glycerin (g) | Reaction time (h) |
|---|---|---|---|
| Mono R1 | 615.3 | 134.9 | 2 |
| Mono R2 | 263.1 | 58.95 | 1 |
| Mono C1 | 621.1 | 135.6 | 3 |
| Mono C2 | 558.8 | 118.7 | 2 |
| Mono C3 | 596.5 | 127.8 | 2:45 |
| Mono G1 | 546.6 | 114 | 3 |
| Mono G2 | 273.0 | 50.7 | 1 |

At the end of the reaction, the resulting liquid was cooled and filtered and directly used for the subsequent reaction of formation of the resin with maleic anhydride.

The mixture of the reagents, monoglyceride and maleic anhydride, suitably weighed, was poured within the same reactor and the reaction was conducted under nitrogen and under stirring at 180 revolutions/minute, first bringing the temperature to 150°C and allowing reaction at this temperature for about an hour, and then increasing the temperature to 220°C and allowing reaction at this temperature for about a further hour.

The quantities of reagents and the total reaction time are indicated for each sample in the following Table 2.

**TABLE 2**

| | Monoglyceride (g) | Maleic anhydride (g) | Reaction time (h) |
|---|---|---|---|
| Resin R1 | 202.6 | 59.6 | 3:25 |
| Resin R2 | 202.4 | 47.3 | 4:15 |
| Resin C1 | 665.0 | 149.6 | 3:45 |
| Resin C2 | 550.2 | 124.8 | 3:00 |
| Resin C3 | 253.0 | 50.9 | 5:20 |
| Resin G1 | 200.5 | 45.4 | 5:30 |
| Resin G2 | 296.9 | 64.1 | 4:20 |

The resin R1 resulted solid and "rubbery" due to an excess of maleic anhydride. These characteristics are not in accordance with the liquid resin that it is desired to obtain, characterized by a viscosity preferably comprised between 10 and 0.5 Pa·s, perhaps even quite high, which could be decreased due to the addition of other types of additives and adjuvants. For this reason it was discarded. The resin R2 was obtained with a quantity of maleic anhydride reduced by 20%.

The resulting liquid resins were cooled and filtered. The resins C1 and C2 resulted turbid due to formation of two phases, and for this reason they were subjected to centrifugation to eliminate the underlying phase.

The liquid resins were mixed with the bis-acylphosphine radical oxide photoinitiator (BAPO - phenylbis(2,4,6-trimethybenzoyl)phosphine oxide), the N-vinyl-pyrrolidone monomer (NVP - N-Vinyl-Pyrrolidone), and the coloring agent Sudan I to give the photosensitive liquid resins usable for the exploratory print tests and in the 3D object print test.

The quantities employed for attaining the exploratory tests are reported in the following table 3.

**TABLE 3**

| | Resin (g) | 2% BAPO (g) | 20% NVP (g) |
|---|---|---|---|
| R_{fot} R2_1 (RAM20) | 3.9 | 0.10 | 1 |
| R_{fot} R2_2 (RAM10) | 4.4 | 0.13 | 0.5 |
| R_{fot} R2_3 (EPR3) | 4.8 | 0.11 | 0.11^{(*)} |
| R_{fot} C2 (COOP20) | 7.81 | 0.22 | 2.01 |
| R_{fot} C3 (COOP30) | 7.87 | 0.20 | 2.27 |
| R_{fot} G1 | 39 | 1^{(**)} | 10 |
| R_{fot} G2 | 133.6 | 3.43 | 35 |

| | | | |
|---|---|---|---|
| (*) The 2% N-Vinyl-Carbazole monomer was used in place of NVP (**) The 2% curcumin radical photoinitiator was used in place of the BAPO. In this case, no other coloring agent was added. | | | |

### Example 2 - Exploratory tests

For the exploratory tests, the following inexpensive and easy-to-find apparatuses were used:
1. A HDMI IBM M400 projector having the following characteristics:
   - Resolution: 1024x768 pixels and 1280x1024;
   - Digital Input: DVI-I;
   - Power: 250 Watt;
   - Contrast: 1800:1;
   - Brightness 1100 lumen;
   - Lifetime of the lamp: 3000 hours;
   - Power of the lamp: 120 Watt;
   - Type of lamp: P-VIP.
2. A Raspberry PI 3 model B which allows, once set in the correct manner, the remote control of the "printer" such that it does not constrain the user to a "direct" use of the instrumentation.
3. An Arduino UNO (Figure 22) which controls, by means of a driver DRV8825, a stepper motor which moves a screw trolley where an aluminum base has been connected. The image of the desired object is projected on such base, once immersed in the polymerizing resin, so as to allow the formation of the various layers.

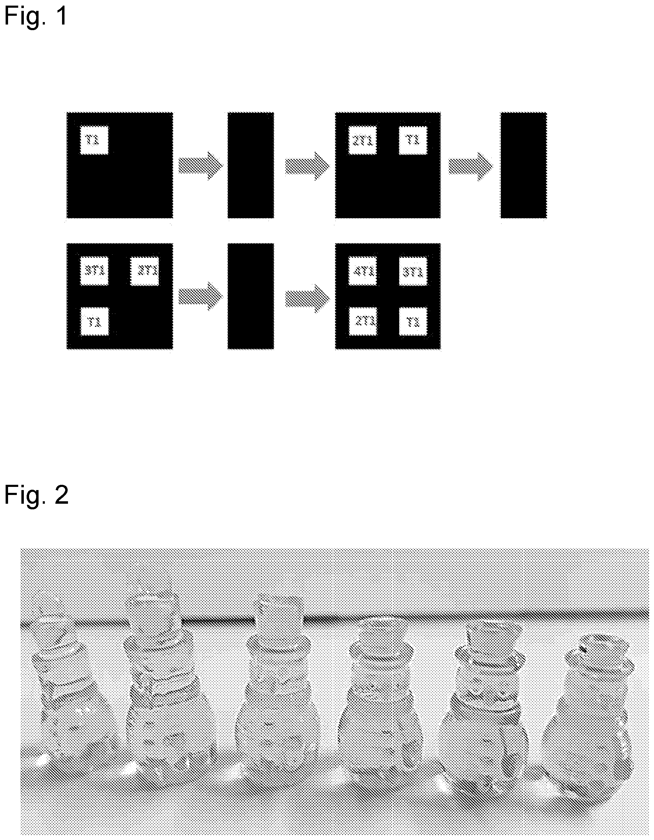

The exploratory tests were carried out in order to verify the actual polymerization of the resin. The suitably-positioned photosensitive resin on an aluminum plate was hit by the light radiation emitted by the DLP projector, which projects squares that appear according to a sequence. In order to establish the times necessary for obtaining a good level of polymerization of the resin layer, the print cycle illustrated in Figure 1 was carried out.

The exposure time for a single layer, i.e. the time interval in seconds in which the photosensitive resin is irradiated, was fixed equal to T1 up to reaching a total time TTOT equal to 4 times T1 (4T1). The wait time Ta, instead, is the time interval in which the light beam is absent (indicated with the black rectangle in Figure 1).

The exposure parameters and the obtained results are illustrated in the following table 4.

**TABLE 4**

| | T1 (s) | Ta | Result |
|---|---|---|---|
| R_{fot} R2_1 (RAM20) | 1.0 | 2.0 | Only the first square polymerized (4T1) |
| R_{fot} R2_2 (RAM10) Test 1 | 2.5 | 2.0 | All four squares polymerized |
| R_{fot} R2_2 (RAM10) Test 2 | 1.0 | 2.0 | All four squares polymerized |
| R_{fot} R2_3 (EPR3) | 2.5 | 2.0 | No polymerization |
| R_{fot} C2 (COOP20) Test 1 | 2.0 | 2.0 | Only the first square polymerized (4T1) |
| R_{fot} C2 (COOP20) Test 2 | 5.0 | 2.0 | All four squares polymerized |
| R_{fot} C3 (COOP30) Test 1 | 2.0 | 2.0 | Only the first square polymerized (4T1) |
| R_{fot} C3 (COOP30) Test 2 | 4.0 | 2.0 | All four squares polymerized |
| R_{fot} G1 | 2.5 | 2.0 | No polymerization |
| R_{fot} G2 | 2.0 | 2.0 | All four squares polymerized |

The exploratory tests led to the definition of the following parameters used in the print tests:
- Exposure time: 8s
- Layer height: 0.2mm
- Wait time: 5s
- Activated immersion: 3mm
- Immersion wait time: 3s

### Example 3 - Print tests

The print tests of the 3D objects were attained with the photosensitive resins illustrated in the following table 5.

**TABLE 5**

| | Resin (g) | 2% BAPO (g) | 20% NVP (g) | Sudan I (mg) |
|---|---|---|---|---|
| R_{fot} R2 (WASTE) | 39.1 | 1 | 10 | 6 |
| R_{fot} C2 (COOP20) | 117.0 | 3 | 30 | 18 |
| R_{fot} C3 (COOP30) | 165.5 | 4.2 | 43 | 24 |
| R_{fot} G2 | 133.6 | 3.43 | 35 | 21 |

Figure 2 illustrates the results obtained with the photosensitive resin R_{fot} R2 with different doses of coloring agent and increasing level of detail.

In particular, from left to right, the concentration of coloring agent increases from 2.5 mg Sudan I/50 mL of resin to 10 mg Sudan I/50 mL with increments between the various tests of 1.25 mg of Sudan I. The exposure time for each 0.2 mm layer is 8 seconds. The penultimate test has an improved level of detail.

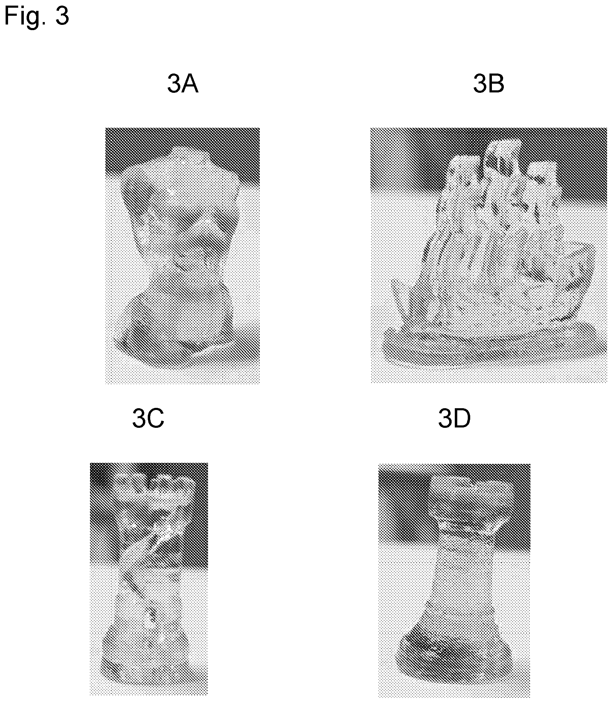

Figures 3A-D illustrate the results obtained with the photosensitive resin R_{fot} G2.

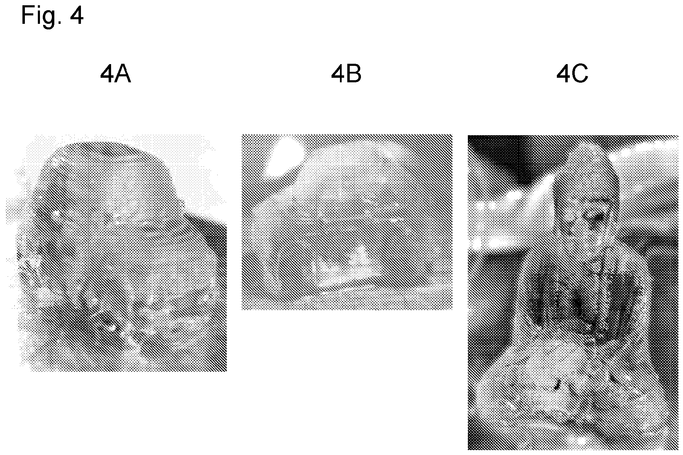

Figures 4A-C illustrate the results obtained with the photosensitive resin R_{fot} C2 and C3.

## Claims

1. A process for producing a photosensitive resin for 3D printing comprising the following steps:
(i) treating a vegetable oil with a polyol selected from the group which consists of polyols comprising 2 to 6 carbon atoms and at least 2 hydroxyl groups to form a monoglyceride,
(ii) reacting the monoglyceride of step (i) with an unsaturated reagent selected from the group which consists of acids, esters or anhydrides comprising at least one carboxylic group and at least one double bond to form a liquid resin with a viscosity measured with a rotational viscometer of lower than 20 Pa·s at the temperature of 20°C,
(iii) mixing the liquid resin with (a) a comonomer selected from the group which consists of vinyl and acrylic monomers, and (b) a photoinitiator.

2. The process for producing a photosensitive resin for 3D printing according to claim 1, wherein said vegetable oil is selected from the group which consists of recovery or fresh food vegetable oils.

3. The process for producing a photosensitive resin for 3D printing according to claim 2, wherein said recovery or fresh food vegetable oils are olive oil, linseed oil, grape seed oil, coconut oil, palm oil and palm-kernel oil, corn oil, sunflower oil, sesame seed oil, wheat germ oil, jojoba oil, hemp oil, castor oil, evening primrose oil, avocado oil, soybean oil, rice bran oil, safflower oil, rape oil, peanut oil, walnut oil, macadamia oil.

4. The process for producing a photosensitive resin for 3D printing according to claim 1, wherein said polyol is selected from the group which consists of ethylene glycol, glycerin, pentaerythritol, adonitol, allitol, altritol, arabinitol, dulcitol, erythritol, galaxitol, glucitol, guliltol, iditol, inositol, isomalt, lactitol, lisitol, maltitol, mannitol, perseitol, ribitol, rhamnitol, sorbitol, talitol, threitol, xylitol, and mixtures thereof.

5. The process for producing a photosensitive resin for 3D printing according to claim 1, wherein said unsaturated reagent is selected from the group which consists of maleic anhydride, succinic anhydride, phthalic anhydride, itaconic anhydride, ethyl maleate, itaconic acid, maleic acid, fumaric acid and mixtures thereof.

6. The process for producing a photosensitive resin for 3D printing according to claim 1, wherein said comonomer is selected from the group which consists of vinyl monomers, such as for example N-vinylpyrrolidone, N-vinylcarbazole, triethylene glycol divinyl ether, vinyltoluene and ethyl maleate, and acrylic monomers, such as for example polyethylene glycol diacrylate, hexanediol diacrylate, methyl methacrylate, methacrylic acid and acrylic acid.

7. The process for producing a photosensitive resin for 3D printing according to claim 1, wherein said photoinitiator is selected from the group which consists of acylphosphine oxides, curcumin, benzophenones and derivatives, camphorquinone, anthraquinones and derivatives, xanthone and derivatives, thioxanthone and derivatives.

8. The process for producing a photosensitive resin for 3D printing according to claim 1, wherein said liquid resin has a viscosity greater than 100 mPa·s at the temperature of 20°C.

9. The process for producing a photosensitive resin for 3D printing according to claim 1, wherein said treatment step (i) occurs at a temperature comprised between 180°C and 230°C, preferably between 200°C and 220°C, for a time comprised between 15 and 180 minutes, preferably between 60 and 120 minutes.

10. The process for producing a photosensitive resin for 3D printing according to claim 1, wherein said reaction step (ii) occurs at two times conducted at different temperature.

11. The process for producing a photosensitive resin for 3D printing according to claim 10, wherein said reaction step (ii) is conducted at a first time by heating up to a temperature comprised between 120°C and 170°C, preferably between 140°C and 160°C, and hence making the reaction to occur at such a temperature for a time comprised between 15 minutes and 2 hours, preferably between 40 and 70 minutes, and subsequently at a second time by heating up to a temperature comprised between 190°C and 220°C, preferably between 200°C and 220°C, and then making the reaction to occur at such a temperature for a time comprised between 15 and 90 minutes, preferably between 20 and 30 minutes.

12. The process for producing a photosensitive resin for 3D printing according to any one of the preceding claims 1 to 11 wherein said treatment step (i) and said reaction step (ii) are conducted in nitrogen atmosphere.

13. The process for producing a photosensitive resin for 3D printing according to claim 1, wherein said mixing step (iii) comprises the addition of a coloring agent.

14. The process for producing a photosensitive resin for 3D printing according to claim 13, wherein said coloring agent is selected from the group which consists of Sudan I, Sudan III, Sudan IV, curcumin, E102 and other liposoluble food coloring agents, preferably of red and yellow color.

15. The process for producing a photosensitive resin for 3D printing according to claim 13, wherein said coloring agent is selected from the group which consists of Sudan I and liposoluble food coloring agents.

16. A photosensitive resin for 3D printing obtained according to the process of claims 1 to 15.

17. A three-dimensional object obtained by a 3D printer using the photosensitive resin of claim 16.

## Patentansprüche

1. Verfahren zur Herstellung eines photosensitiven Harzes für den 3D-Druck, das die folgenden Schritte umfasst:
(i) Behandeln eines Pflanzenöls mit einem Polyol, das aus der Gruppe ausgewählt ist, die aus Polyolen, die 2 bis 6 Kohlenstoffatome und mindestens 2 Hydroxylgruppen umfassen, besteht, um ein Monoglycerid zu bilden,
(ii) Umsetzen des Monoglycerids aus Schritt (i) mit einem ungesättigten Reagenz, das aus der Gruppe ausgewählt ist, die aus Säuren, Estern oder Anhydriden besteht, die mindestens eine Carboxylgruppe und mindestens eine Doppelbindung umfassen, um ein flüssiges Harz mit einer Viskosität von weniger als 20 Pa·s bei einer Temperatur von 20°C, gemessen mit einem Rotationsviskosimeter, zu bilden,
(iii) Mischen des flüssigen Harzes mit (a) einem Comonomer, das aus der Gruppe ausgewählt ist, die aus Vinyl- und Acrylmonomeren besteht und (b) einem Photoinitiator.

2. Verfahren zur Herstellung eines photosensitiven Harzes für den 3D-Druck nach Anspruch 1, wobei das Pflanzenöl aus der Gruppe ausgewählt ist, die aus Pflanzenölen aus Rückgewinnung oder frischen Lebensmitteln besteht.

3. Verfahren zur Herstellung eines photosensitiven Harzes für den 3D-Druck nach Anspruch 2, wobei die Pflanzenöle aus Rückgewinnung oder frischen Lebensmitteln Olivenöl, Leinöl, Traubenkernöl, Kokosnussöl, Palmöl und Palmkernöl, Maisöl, Sonnenblumenöl, Sesamsamenöl, Weizenkeimöl, Jojobaöl, Hanföl, Rizinusöl, Nachtkerzenöl, Avocadoöl, Sojaöl, Reiskleieöl, Färberdistelöl, Rapsöl, Erdnussöl, Walnussöl und Macadamiaöl sind.

4. Verfahren zur Herstellung eines photosensitiven Harzes für den 3D-Druck nach Anspruch 1, wobei das Polyol aus der Gruppe ausgewählt ist, die aus Ethylenglykol, Glycerin, Pentaerythritol, Adonitol, Allitol, Altritol, Arabinitol, Dulcitol, Erythritol, Galaxitol, Glucitol, Guliltol, Iditol, Inositol, Isomalt, Lactitol, Lisitol, Maltitol, Mannitol, Perseitol, Ribitol, Rhamnitol, Sorbitol, Talitol, Threitol, Xylitol und Mischungen davon besteht.

5. Verfahren zur Herstellung eines photosensitiven Harzes für den 3D-Druck nach Anspruch 1, wobei das ungesättigte Reagenz aus der Gruppe ausgewählt ist, die aus Maleinsäureanhydrid, Bernsteinsäureanhydrid, Phthalsäureanhydrid, Itaconsäureanhydrid, Ethylmaleat, Itaconsäure, Maleinsäure, Fumarsäure und deren Mischungen besteht.

6. Verfahren zur Herstellung eines photosensitiven Harzes für den 3D-Druck nach Anspruch 1, wobei das Comonomer aus der Gruppe ausgewählt ist, die aus Vinylmonomeren, wie zum Beispiel N-Vinylpyrrolidon, N-Vinylcarbazol, Triethylenglykoldivinylether, Vinyltoluol und Ethylmaleat, und Acrylmonomeren, wie zum Beispiel Polyethylenglykoldiacrylat, Hexandioldiacrylat, Methylmethacrylat, Methacrylsäure und Acrylsäure, besteht.

7. Verfahren zur Herstellung eines photosensitiven Harzes für den 3D-Druck nach Anspruch 1, wobei der Photoinitiator aus der Gruppe ausgewählt ist, die aus Acylphosphinoxiden, Curcumin, Benzophenonen und Derivaten, Campherchinon, Anthrachinonen und Derivaten, Xanthon und Derivaten, Thioxanthon und Derivaten, besteht.

8. Verfahren zur Herstellung eines photosensitiven Harzes für den 3D-Druck nach Anspruch 1, wobei das flüssige Harz eine Viskosität von mehr als 100 mPa·s bei einer Temperatur von 20°C aufweist.

9. Verfahren zur Herstellung eines photosensitiven Harzes für den 3D-Druck nach Anspruch 1, wobei der Behandlungsschritt (i) bei einer Temperatur, die zwischen 180°C und 230°C, bevorzugt zwischen 200°C und 220°C, umfasst, für eine Zeit, die zwischen 15 und 180 Minuten, bevorzugt zwischen 60 und 120 Minuten, umfasst, erfolgt.

10. Verfahren zur Herstellung eines photosensitiven Harzes für den 3D-Druck nach Anspruch 1, wobei der Reaktionsschritt (ii) zu zwei Zeiten durchgeführt bei unterschiedlicher Temperatur erfolgt.

11. Verfahren zur Herstellung eines photosensitiven Harzes für den 3D-Druck nach Anspruch 10, wobei der Reaktionsschritt (ii) zu einer ersten Zeit durch Erhitzen auf eine Temperatur, die zwischen 120°C und 170°C, bevorzugt zwischen 140°C und 160°C, umfasst, durchgeführt wird, und somit die Reaktion bei einer solchen Temperatur für eine Zeit, die zwischen 15 Minuten und 2 Stunden, bevorzugt zwischen 40 und 70 Minuten, umfasst, erfolgen zu lassen, und anschließend zu einer zweiten Zeit durch Erhitzen auf eine Temperatur, die zwischen 190°C und 220°C, bevorzugt zwischen 200°C und 220°C, umfasst, und folglich die Reaktion bei einer solchen Temperatur für eine Zeit, die zwischen 15 und 90 Minuten, bevorzugt zwischen 20 und 30 Minuten, umfasst, erfolgen zu lassen.

12. Verfahren zur Herstellung eines photosensitiven Harzes für den 3D-Druck nach einem der vorhergehenden Ansprüche 1 bis 11, wobei der Behandlungsschritt (i) und der Reaktionsschritt (ii) in Stickstoffatmosphäre durchgeführt werden.

13. Verfahren zur Herstellung eines photosensitiven Harzes für den 3D-Druck nach Anspruch 1, wobei der Mischschritt (iii) die Zugabe eines Farbstoffs umfasst.

14. Verfahren zur Herstellung eines photosensitiven Harzes für den 3D-Druck nach Anspruch 13, wobei der Farbstoff aus der Gruppe ausgewählt ist, die aus Sudan I, Sudan III, Sudan IV, Curcumin, E102 und anderen fettlöslichen Lebensmittelfarbstoffen, bevorzugt von roter und gelber Farbe, besteht.

15. Verfahren zur Herstellung eines photosensitiven Harzes für den 3D-Druck nach Anspruch 13, wobei der Farbstoff aus der Gruppe ausgewählt ist, die aus Sudan I und fettlöslichen Lebensmittelfarbstoffen besteht.

16. Photosensitives Harz für den 3D-Druck, erhältlich durch ein Verfahren nach Ansprüche 1 bis 15.

17. Dreidimensionales Objekt, das mit einem 3D-Drucker unter Verwendung des photosensitiven Harzes nach Anspruch 16 erhalten wird.

## Revendications

1. Procédé de production d'une résine photosensible pour l'impression 3D comprenant les étapes suivantes :
(i) traitement d'une huile végétale avec un polyol sélectionné dans le groupe qui est constitué des polyols comprenant de 2 à 6 atomes de carbone et au moins 2 groupes hydroxyle pour former un monoglycéride,
(ii) réaction du monoglycéride de l'étape (i) avec un réactif insaturé sélectionné dans le groupe qui est constitué des acides, des esters ou des anhydrides comprenant au moins un groupe carboxylique et au moins une double liaison pour former une résine liquide ayant une viscosité, mesurée avec un viscosimètre rotatif, inférieure à 20 Pa·s à la température de 20°C,
(iii) mélange de la résine liquide avec (a) un comonomère sélectionné dans le groupe qui est constitué des monomères de vinyle et acryliques, et (b) d'un photo-initiateur.

2. Procédé de production d'une résine photosensible pour l'impression 3D selon la revendication 1, ladite huile végétale étant sélectionnée dans le groupe qui est constitué des huiles végétales alimentaires de récupération ou fraîches.

3. Procédé de production d'une résine photosensible pour l'impression 3D selon la revendication 2, lesdites huiles végétales alimentaires de récupération ou fraîches étant l'huile d'olive, l'huile de graines de lin, l'huile de pépins de raisin, l'huile de noix de coco, l'huile de palme et l'huile de noix de palmiste, l'huile de maïs, l'huile de tournesol, l'huile de graines de sésame, l'huile de germe de blé, l'huile de jojoba, l'huile de chanvre, l'huile de ricin, l'huile d'onagre, l'huile d'avocat, l'huile de fèves de soja, l'huile de son de riz, l'huile de carthame, l'huile de colza, l'huile d'arachide, l'huile de noix, l'huile de macadamia.

4. Procédé de production d'une résine photosensible pour l'impression 3D selon la revendication 1, ledit polyol étant sélectionné dans le groupe qui est constitué de l'éthylène glycol, de la glycérine, du pentaérythritol, de l'adonitol, de l'allitol, de l'altritol, de l'arabinitol, du dulcitol, de l'érythritol, du galaxitol, du glucitol, du guliltol, de l'iditol, de l'inositol, de l'isomalt, du lactitol, du lisitol, du maltitol, du mannitol, du perseitol, du ribitol, du rhamnitol, du sorbitol, du talitol, du thréitol, du xylitol, et de leurs mélanges.

5. Procédé de production d'une résine photosensible pour l'impression 3D selon la revendication 1, ledit réactif insaturé étant sélectionné dans le groupe qui est constitué de l'anhydride maléique, de l'anhydride succinique, de l'anhydride phtalique, de l'anhydride itaconique, du maléate d'éthyle, de l'acide itaconique, de l'acide maléique, de l'acide fumarique et de leurs mélanges.

6. Procédé de production d'une résine photosensible pour l'impression 3D selon la revendication 1, ledit comonomère étant sélectionné dans le groupe qui est constitué des monomères de vinyle, tels que par exemple de la *N*-vinylpyrrolidone, du N-vinylcarbazole, de l'éther divinylique de triéthylène glycol, du vinyltoluène et du maléate d'éthyle, et des monomères acryliques, tels que par exemple le diacrylate de polyéthylène glycol, le diacrylate d'hexanediol, le méthacrylate de méthyle, l'acide méthacrylique et l'acide acrylique.

7. Procédé de production d'une résine photosensible pour l'impression 3D selon la revendication 1, ledit photo-initiateur étant sélectionné dans le groupe qui est constitué des oxydes d'acylphosphine, de la curcumine, des benzophénones et leurs dérivés, de la camphorquinone, des anthraquinones et leurs dérivés, de la xanthone et dérivés, de la thioxanthone et dérivés.

8. Procédé de production d'une résine photosensible pour l'impression 3D selon la revendication 1, ladite résine liquide ayant une viscosité supérieure à 100 mPa·s à la température de 20°C.

9. Procédé de production d'une résine photosensible pour l'impression 3D selon la revendication 1, ladite étape de traitement (i) survenant à une température comprise entre 180°C et 230°C, préférablement entre 200°C et 220°C, sur une durée comprise entre 15 et 180 minutes, préférablement entre 60 et 120 minutes.

10. Procédé de production d'une résine photosensible pour l'impression 3D selon la revendication 1, ladite étape réactionnelle (ii) survenant à deux moments conduite à une température différente.

11. Procédé de production d'une résine photosensible pour l'impression 3D selon la revendication 10, ladite étape réactionnelle (ii) étant conduite à un premier moment par chauffage jusqu'à une température comprise entre 120°C et 170°C, préférablement entre 140°C et 160°C, et ainsi faisant que la réaction se produit à une telle température sur une durée comprise entre 15 minutes et 2 heures, préférablement entre 40 et 70 minutes, et par la suite à un second moment par chauffage jusqu'à une température comprise entre 190°C et 220°C, préférablement entre 200°C et 220°C, et ensuite faisant que la réaction se produit à une telle température sur une durée comprise entre 15 et 90 minutes, préférablement entre 20 et 30 minutes.

12. Procédé de production d'une résine photosensible pour l'impression 3D selon l'une quelconque des revendications précédentes 1 à 11, ladite étape de traitement (i) et ladite étape réactionnelle (ii) étant conduites sous une atmosphère d'azote.

13. Procédé de production d'une résine photosensible pour l'impression 3D selon la revendication 1, ladite étape de mélange (iii) comprenant l'addition d'un agent colorant.

14. Procédé de production d'une résine photosensible pour l'impression 3D selon la revendication 13, ledit agent colorant étant sélectionné dans le groupe qui est constitué du Soudan I, du Soudan III, du Soudan IV, de la curcumine, de l'E102 et d'autres agents colorants alimentaires liposolubles, préférablement de couleur rouge et jaune.

15. Procédé de production d'une résine photosensible pour l'impression 3D selon la revendication 13, ledit agent colorant étant sélectionné dans le groupe qui est constitué des agents colorants Soudan I et alimentaires liposolubles.

16. Résine photosensible pour l'impression 3D obtenue selon le procédé selon les revendications 1 à 15.

17. Objet tridimensionnel obtenu par une imprimante 3D en utilisant la résine photosensible selon la revendication 16.
